# EUROPEAN PATENT APPLICATION

(11) **EP 4 484 320 A1**
(43) Date of publication of application: **01.01.2025**
(21) Application number: 23182611.6
(22) Date of filing: 30.06.2023
(51) Int. Cl.: B65D 6/18, B65D 21/08, G09F 3/03, G01R 33/07

(54) **REUSABLE PACKAGE WITH AN ELECTRONIC SEAL FOR USE IN A PARCEL DISTRIBUTION SYSTEM**

(71) Applicant: SwipBox Development ApS, 6400 Sønderborg (DK)
(72) Inventor: Kaczmarek, Allan, 6400 Sønderborg (DK)
(74) Representative: Patrade A/S

(57) **Abstract**

A reusable package (10) for use in a parcel distribution system, the package (10) comprising
- a base (20) and an opposite lid (30) defining an internal space (12), wherein the package (10) comprises a closable opening (32) for enabling access to the internal space (12), the closeable opening (32) being closable along a strip (50) by a reversible slide fastener (52) or hook and loop tape (58);
- a first mating unit (14) positioned on the package (10);
- a flap (60) extending from the package (10), wherein the flap (10) and the first mating unit (14) are positioned on opposite sides of the strip (50), the flap (60) including a second mating unit (62) complementary to the first mating unit (14);
- an electronic seal (70) including a sensor (72) configured for detecting whether the mating units (14,62) are coupled and/or uncoupled;
- a smart tag (80) connected to the sensor (72), the smart tag (80) comprising a local power storage (81), a communication module (82), a processor (84) and a computer-readable medium (86) having stored thereon a computer program causing the processor (84) to determine a change of state as a function of data from the sensor between
- a broken seal state (100), wherein the mating units (14,62) are uncoupled; and
- a connected seal state (200) wherein the mating units (14,62) are coupled,

wherein the computer program further causes the processor to store state history on the computer-readable medium (86).

## Description

### Field of the Invention

The present invention relates to a reusable package for use in a parcel distribution system, where the package is provided with an electronic seal to detect whether the package has been opened, and the electronic seal is reversible.

### Background of the Invention

The number of parcels globally is increasing year by year and presently cardboard is used for constructing the parcels as it is a relatively cheap material with proper material properties for transportation. However, the material is in general used once before at least part of the cardboard is recycled. Thus, the carbon footprint stemming from cardboard use in the parcel distribution industry is too high and there is an increased focus on finding alternative solutions. The cardboard parcel is in most cases sealed using tape, which is cheap and easy to handle, while providing a minimum of security. However, any person can open a taped cardboard parcel and afterwards reapply the tape. In some cases, national customs or courier services are required to open a parcel and thus the parcel should be openable. The need for a parcel which has a basic level of security, but can still be opened by customs and/or courier services, has prevented widespread integration of alternative solutions.

LivingPackets proposes a collapse package of expanded polystyrene including a computer with additional features in an attempt to offset the increased costs of the package. The package includes an electronic lock and a TSA lock for allowing access to customs. This solution is reversible but requires the user to have the correct key or means for communicating with the electronic lock.

Returnity (US) proposes various reusable bags and packages which can be reused a multiple number of times. The package is made more tamper proof by a colored cable tie or strip lock while allowing for easy access and application of a new cable tie or strip lock.

Limeloop also proposes various reusable packages which can be reused a multiple number of times. The package is made more tamper proof by a colored cable tie or strip lock while allowing for easy access and application of a new cable tie or strip lock.

These packages are to be reused several times and rarely will the item or items to be shipped match. In many cases, these packages must be used more than 20 times to be able to compete with the cost of cardboard. However, the solutions from Returnity and Limeloop still generate waste when breaking the cable tie or strip lock, while the LivingPackets solution is time consuming and requires additional items to open. Thus, there is a need for an alternative solution, which generates zero waste while allowing opening of the parcel or package without additional tools.

Furthermore, CO2-wise, the most efficient distribution system would be a decentralized system where the reusable packages are not required to return to the sender but instead can flow freely between various couriers, recipients and senders. Solutions proposed by Returnity and Limeloop are not suitable for use in decentralized systems as they require cable ties or strip locks, which a person would then be required to apply.

Thus, there is a need for a package for shipping in a parcel distribution system with a reusable and reversible seal, where no additional items are needed to open the package.

### Object of the Invention

It is an object of the invention to provide a reusable package for use in a parcel distribution system, where the package is provided with an electronic seal to detect whether the package has been opened, and the electronic seal is reversible.

### Description of the Invention

An object of the invention is achieved by a reusable package for use in a parcel distribution system. The package comprises
- a base and an opposite lid defining an internal space, wherein the package comprises a closable opening for enabling access to the internal space, the closeable opening being closable along a strip by a reversible slide fastener or hook and loop tape;
- a first mating unit positioned on the package;
- a flap extending from the package, wherein the flap and the first mating unit are positioned on opposite sides of the strip, the flap including a second mating unit complementary to the first mating unit, wherein the flap is configured to extend past the strip, such that the mating units can couple;
- an electronic seal including a sensor configured for detecting whether the mating units are coupled and/or uncoupled;
- a smart tag connected to the sensor, the smart tag comprises a local power storage, a communication module, a processor and a computer-readable medium having stored thereon a computer program causing the processor to determine a change of state as a function of data from the sensor between
- a broken seal state, wherein the mating units are uncoupled; and
- a connected seal state wherein the mating units are coupled,
wherein the computer program further causes the processor to store state history on the computer-readable medium.

The smart tag and the electronic tag can simply just open the package as this opening is stored on the computer-readable medium such that the recipient or a courier can see information regarding change of state. The reusable package assumes that the package has been opened when the state is the broken seal state as there is no other reason to uncouple the mating units. In preferred embodiments the stored state history is stored along with a timestamp and in these embodiments the smart tag includes a clock unit.

A recipient, a courier service required to check the item or items stored inside the internal space, or a customs authority can simply just open the package by uncoupling the mating units and unzipping the slide fastener or separating the hook and loop tape. The recipient may collect the item or items, while the courier or customs authority can inspect the items. Afterwards, the recipient can close the package with the slide fastener, or the hook and loop tape and the reusable package can be reused for another sender. The courier service and the customs authority simply close the package and let the package continue along its shipping route without need of a key, or cable tie or strip lock.

The reusable package may have any shape such as cylindrical, box-shaped, triangular, or any other shape.

The sensor may be configured to only detect whether the mating units are coupled or uncoupled. Since the mating units can only be in two states, if the mating units are not in one state, then the mating units must be in a different state. In some embodiments, the sensor can detect both states. The smart tag may be positioned anywhere on the reusable package, however in most cases the smart tag will be positioned in a tag pocket on the lid or on a wall extending between the lid and the base. The smart tag may include a clock unit for determining a time stamp.

The local power storage may be a battery unit such as primary batteries or rechargeable batteries. The state history can be provided to a person via the communication module.

The communication module may be a wired communication module and/or a wireless communication module utilizing a WLAN-protocol, such as Bluetooth, Bluetooth Low-Energy, RFID, NFC or similar.

The reusable package is throughout the application described as having a single flap and a single pair of mating units and a single electronic seal. However, the reusable package can have two, three or more flaps, pairs of mating units and electronic seals without changing the spirit of the invention.

In an aspect, the flap may comprise a width greater than the length of the slider and the puller of the slide fastener, such that the slider and the puller are inaccessible without uncoupling the mating units. In the embodiment, where the package comprises a slide fastener along the strip, then the flap may be designed with a width sufficiently greater than the slider and the puller, such that the slider and the puller are inaccessible without uncoupling the mating units, thereby it becomes more difficult to open the reusable package without being detected by the electronic seal.

The person locking the reusable package will be responsible for placing the slide fastener such that the flap can overlap and hide the slide fastener.

In an aspect, the sensor may be a hall sensor positioned on the flap at or near the second mating unit, and the package comprises permanent magnetic material at or near the first mating unit. Thereby, the sensor will be able to detect even efforts of tampering with the flap since a hall sensor is very sensitive. In some embodiments, the mating units are complementary hook and loop mating surfaces and thus the hall sensor may detect a partial uncoupling of the mating surfaces. The detection will be stored in the state history. This is especially relevant when the flap is designed to overlap one or more slide fasteners along the strip.

In an aspect, the sensor may be a hall sensor positioned on the package at or near the first mating unit, and the flap comprises permanent magnetic material at or near the second mating unit. Thereby, the sensor will be able to detect even efforts of tampering with the flap since a hall sensor is very sensitive. In some embodiments, the mating units are complementary hook and loop mating surfaces and thus the hall sensor may detect a partial uncoupling of the mating surfaces. The detection will be stored in the state history. This is especially relevant when the flap is designed to overlap one or more slide fasteners along the strip.

The sensor may be a magnetic field sensor.

In an aspect, the mating units may include complementary button parts, wherein the electronic seal comprises an electronic circuit going through the button parts and the sensor configured to measure the voltage drop and or resistance of the electronic circuit. Thereby, a simple and reliable solution is provided as the button parts form the button. One of the button parts may be a male button part and the other button part is a female button part which can be clicked together.

In an aspect, the mating units comprise complementary hook and loop tape. The hooks or the loops can be positioned on both mating units, but the other mating unit must be complementary. The hook and loop tape is a reversible solution to extend over the strip which provides a sufficient protection. The flap will move less relative to buttons or clips which makes it more suitable for use in conjunction with the permanent magnet and the hall sensor.

In an aspect, the smart tag may include a display and the computer program is further configured to cause the display to show the state history. Thereby, the person handling the package can directly identify the state history without being required to use a device, such as a smart phone, to communicate with the communication module of the smart tag. The display is preferably a bistable display, such as an e-ink display or similar, in order to reduce the overall power consumption of the smart tag.

The smart tag may be positioned in a tag pocket on the outer side or the inner side of the package. The tag pocket will comprise a transparent foil for protecting the smart tag while making the display readable.

In an aspect, the smart tag is further configured to receive unique identifiers about the person or legal entity causing a change of state before or after the change of state. A courier company, such as DHL, must open all packages before a flight to ensure that the content is allowed on the flight, or a customs authority may open any number of packages. The communication module may in these cases receive a unique identifier from the person handling the package, or by the courier company, or the customs authority. This can be performed automatically or semi automatically by the communication module upon detection of a change of state, then the computer program may cause the communication module to either advertise or to actively searching for a signal. The person handling the package, or the courier company, or the customs authority may have a beacon providing a unique identification without performing any active acts. However, the person handling the packets may use an NFC unit and place the NFC unit near the NFC reader of the smart tag and thereby provide the unique identifier.

In an aspect, the smart tag is further configured to reset the state history as a function of received instructions. When a recipient has collected the item or items inside the internal space, then the person may instruct the smart tag to reset via input unit on the smart tag or by sending instructions to the communication module. The instructions will in most cases be generated by a distribution server such that the instructions can be encrypted and thereby only readable by the specific smart tag.

In other cases, the smart tag resets state history upon receiving a new shipping address.

In an aspect, the slider and/or the puller of the slide fastener include permanent magnetic material and the sensor is a hall sensor positioned on the flap at an overlap with the slide fastener during use. Thereby, the slider and/or the puller cannot be removed from under the flap without causing a detection of change of state. Thereby, the package becomes even more tamper proof, but any person can still open the package.

In an aspect, the electronic seal includes one or more tilt sensors and/or gyroscopes and/or accelerometers attached to the closeable opening and the computer program is further configured to cause the processor to determine a change of state as a function of data including data from the one or more tilt sensors and/or gyroscopes and/or accelerometers.

The additional sensors will further improve the package's ability to detect a change of state based on the data from the tilt sensors, gyroscope and/or accelerometers.

In an aspect, the package may comprise one or more walls extending between the base and the lid. The walls will in part determine the shape of the package and at the same time increase the volume of the internal space.

In an aspect, the closeable opening forms part of the lid and the electronic seal further includes one or more tilt sensors and/or gyroscopes and/or accelerometers attached to the base and/or one or more walls, wherein the computer program is further configured to cause the processor to determine a change of state as a function of comparing data between tilt sensors and/or gyroscopes and/or accelerometers attached to the closeable opening and attached to the one or more walls and/or base. If the closeable opening moves and the other parts of the package are stationary, then it is highly likely that the closeable opening is being opened. Thus, the additional number of sensors further increases the tamper proofness of the closeable package.

In an aspect, the package is made of recyclable plastics or fabrics such as cloth. Thereby, the carbon footprint of the package is kept low.

### Description of the Drawing

Embodiments of the invention will be described in the figures, whereon:
Fig. 1 illustrates two embodiments of the package;
Fig. 2 illustrates an embodiment of an open package;
Fig. 3 illustrates two additional embodiments of the package;
Fig. 4 illustrates a lid with a smart tag and components of the smart tag;
Fig. 5 illustrates a first embodiment of the electronic seal;
Fig. 6 illustrates a second embodiment of the electronic seal;
Fig. 7 illustrates a third embodiment of the electronic seal;
Fig. 8 illustrates an embodiment of the package wherein the puller and slider are positioned under the flap.

### Detailed Description of the Invention

| **Item** | **No** |
|---|---|
| Package | 10 |
| Internal space | 12 |
| First mating unit | 14 |
| Tag pocket | 18 |
| Base | 20 |
| Lid | 30 |
| Closeable opening | 32 |
| Wall | 40 |
| Strip | 50 |
| Slide fastener | 52 |
| Slider | 54 |
| Puller | 56 |
| Permanent magnetic material | 57 |
| Hook and loop tap | 58 |
| Button, button mating part | 59 |
| Flap | 60 |
| Second mating unit | 62 |
| Electronic seal | 70 |
| Sensor | 72 |
| Hall sensor | 74 |
| Electronic circuit | 76 |
| Smart tag | 80 |
| Local power storage | 81 |
| Communication module | 82 |
| Processor | 84 |
| Computer-readable medium | 86 |
| Display | 88 |
| Broken seal state | 100 |
| Connected seal state | 200 |

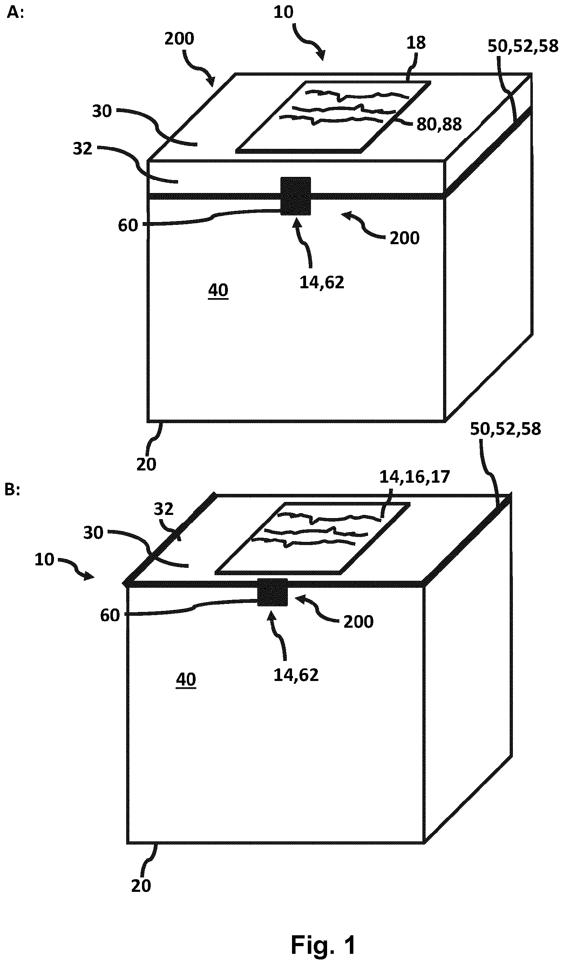

Fig. 1 illustrates two embodiments of the package 10. The packages 10 are very similar and the purpose of both is for use in a distribution system.

Each package 10 comprises a base 20 and an opposite lid 30 defining an internal space 12 in between the base 20 and the lid 30. The embodiments have four walls 40 extending between the base 20 and the lid 30 thereby forming a box. Any other shape is possible, and any other number of walls are possible. The difference between the two embodiments 1A, 1B is the size of the lid 30 and the relative position of a strip 50.

Each package 10 has a closable opening 32 for enabling access to the internal space 12. The closeable opening 32 is closable along the strip 50 by a reversible slide fastener 52 or by hook and loop tape 58. The slide fastener 52 is the simplest solution as the slide fastener 52 will not reattach accidently.

Each package 10 has a first mating unit 14 positioned on the package 10 and a flap 60 extending from the package 10. The flap 10 and the first mating unit 14 are positioned on opposite sides of the strip 50 the flap 60 including a second mating unit 62 complementary to the first mating unit 14.

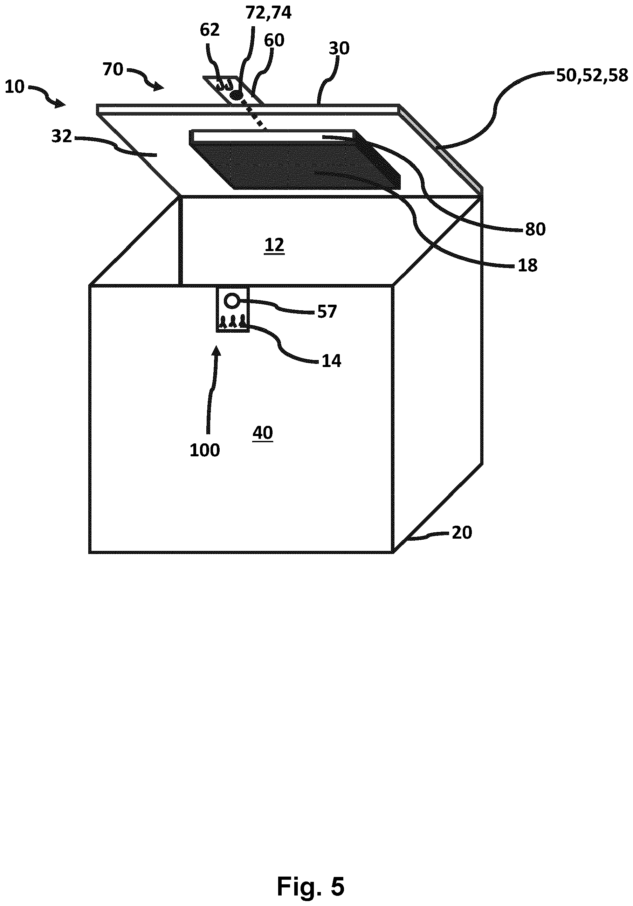

Each package 10 has an electronic seal 70 (not shown) including a sensor 72 configured for detecting whether the mating units 14,62 are coupled and/or uncoupled. The electronic seal 70 and the sensor 72 is shown in figures 5 to 8.

Each package 10 has a smart tag 80 connected to the sensor 72, the smart tag 80 comprising a local power storage 81, a display 88, a communication module 82, a processor 84 and a computer-readable medium 86 having stored thereon a computer program causing the processor 84 to determine a change of state as a function of data from the sensor between
- a broken seal state 100, wherein the mating units 14,62 are uncoupled; and
- a connected seal state 200 wherein the mating units 14,62 are coupled,
wherein the computer program further causes the processor to store state history on the computer-readable medium 86.

Each package 10 may have a smart tag 80 including a clock unit for timestamping the change of state.

Each package 10 has a tag pocket 18 for holding the smart tag 80. The tag pocket may include a transparent foil to make the display 88 readable.

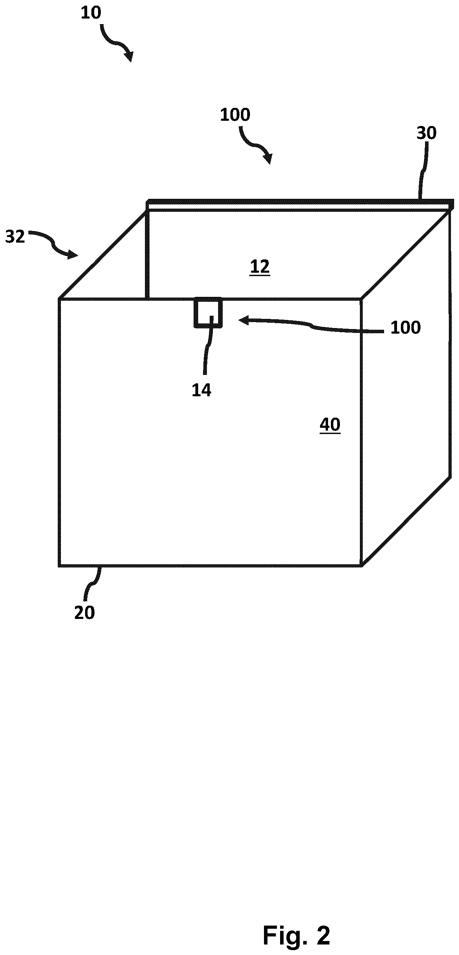

Fig. 2 illustrates an embodiment of an open package 10 revealing the internal space 12 which may hold one or more items. The open package 10 could be any of the shown two embodiments in figure 1 and thus could have all the same features. The shown package 10 has a first mating unit 14 attached to the package 10. The open package 10 is in a broken seal state 100.

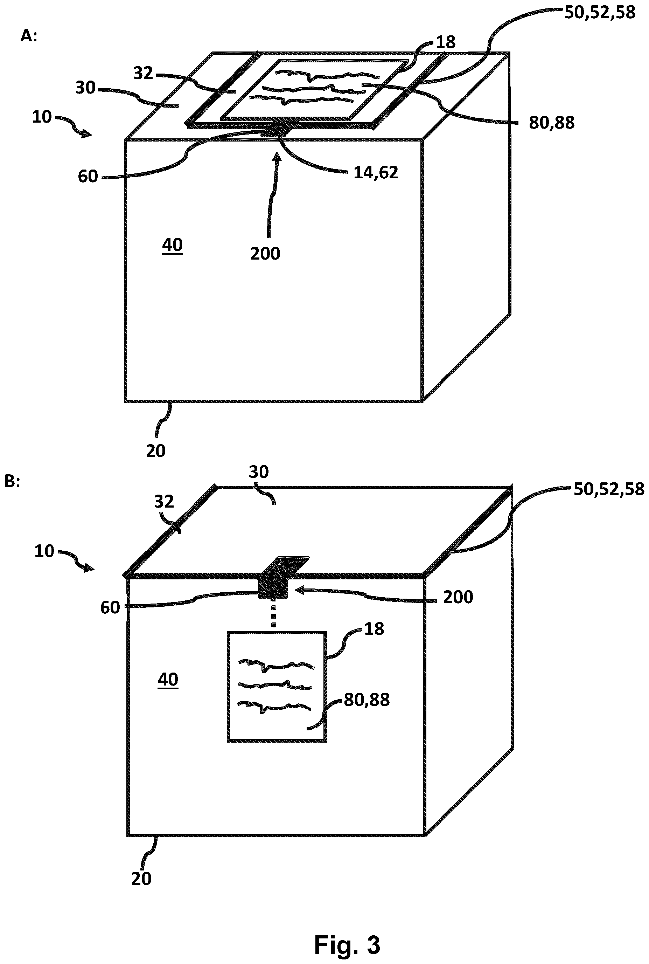

Fig. 3 illustrates additional two embodiments of the package 10. In figure 3A, the closeable opening does not form part of the entire lid 30, but the smart tag 80 is still positioned on the closeable opening 32. The flap 60 extends from the closeable opening 32 forming part of the lid 30 to a first mating unit 14 positioned on the lid 30. The flap 60 comprising a second mating unit 62 complementary to the first mating unit 14.

In figure 3B, the closeable opening does form part of the entire lid 30 and the strip 50 is in the interface between the walls 40 and the lid 30. The smart tag 80 is positioned in a tag pocket 18 on one of the walls 40. The flap 60 extends from the lid 30 to a first mating unit 14 positioned on the wall 30 between the smart tag 80 and the slide 50. The flap 60 comprising a second mating unit 62 complementary to the first mating unit 14. A connection between the smart tag 80 and a sensor 72 (not shown) of an electronic seal 70 is illustrated by a dotted line.

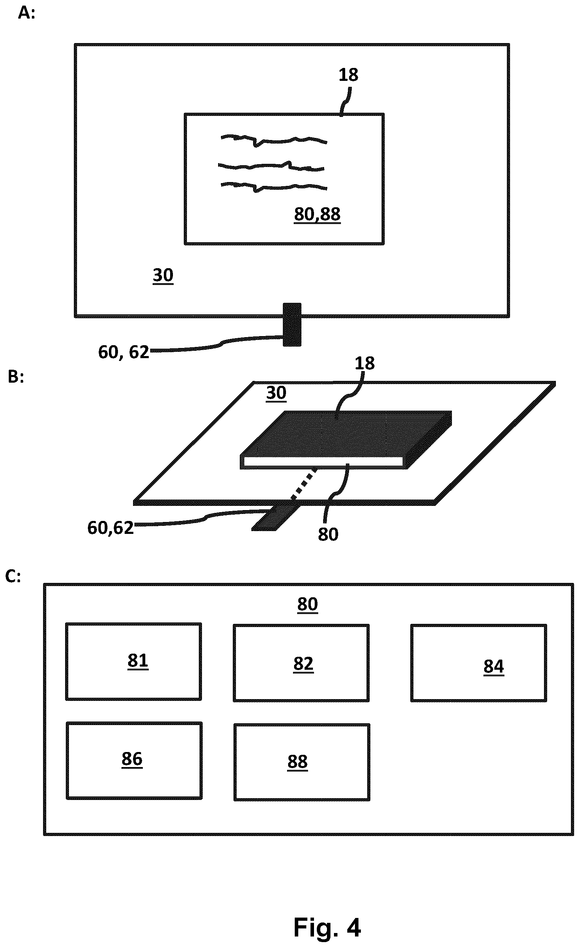

Figure 4A discloses a top side view of a lid 30 with a smart tag 80 having a display 88. Figure 4B discloses a bottom side view of the lid 30 shown in figure 4A. The smart tag 80 is positioned in a tag pocket on the bottom side of the lid 30. An electronic connection is shown as the dotted line, which illustrates the connection to a not shown sensor 72 of the electronic seal 70. A flap 60 with a second mating unit 62 extends from the lid 30.

Figure 4C illustrates components of a smart tag 80. The smart tag 80 comprises a local power storage 81 such as a battery unit with primary batteries or rechargeable batteries. The smart tag further comprises a communication module 82 which may communicate via wired means or via a wireless protocol such as WLAN, Bluetooth, Bluetooth low-energy (BLE), RFID and/or NFC. NFC and BLE are preferred. The smart tag 80 comprises a processor 84 and a computer-readable medium 86 having stored thereon a computer program causing the processor 84 to determine a change of state as a function of data from the sensor between a broken seal state 100, wherein the mating units 14,62 are uncoupled, and a connected seal state 200 wherein the mating units 14,62 are coupled. The computer program is further configured to cause the processor to store state history on the computer-readable medium 86.

The smart tag 80 may comprise a display 88 and the display 88 may be a bistable display such as an e-ink display.

The smart tag 80 may further comprise a clock unit for timestamping the change of state.

Fig. 5 illustrates a first embodiment of the electronic seal 70. The electronic seal 70 is part of a package 10 as described in the other figures 1-3. The lid 30 has a flap 60 with a second mating unit 62 in the form of hooks. One of the walls 40 of the package comprises a first mating unit 14 in the form of loops. The mating units 14, 62 together form a hook and loop tape.

The smart tag 80 is connected to a sensor 72, which is a Hall sensor 74 for detecting changes to the magnetic field. The package also includes a permanent magnetic material 57 positioned at the first mating unit 14. If the package 10 is closed, then the package 10 will be more or less identical to the embodiment shown in figure 1B, and the state of the package 10 would be the connected seal state 200. In the present case the mating units 14, 62 have been uncoupled, which has caused a change in magnetic field at the Hall sensor 74 and thereby the change of state into the broken seal state has been detected.

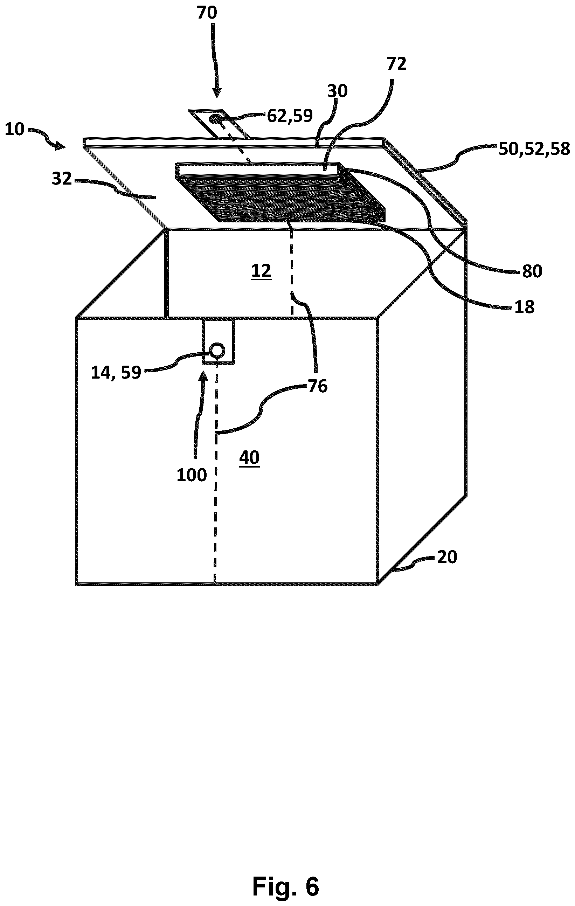

Fig. 6 illustrates a second embodiment of the electronic seal 70. The electronic seal 70 is part of a package 10 as described in the other figures 1-3. The lid 30 has a flap 60 with a second mating unit 62 in the form of a button part 59. One of the walls 40 of the package comprises a first mating unit 14 in the form of a complementary button part 59. The mating units 14, 62 together form a button 59. The electronic seal 70 comprises an electronic circuit 76 going through the button parts 59, and the sensor 72 is configured to measure the voltage drop and or resistance of the electronic circuit 76. In this embodiment the sensor forms part of the smart tag 80, however it could be a separate unit in communication with the smart tag 80.

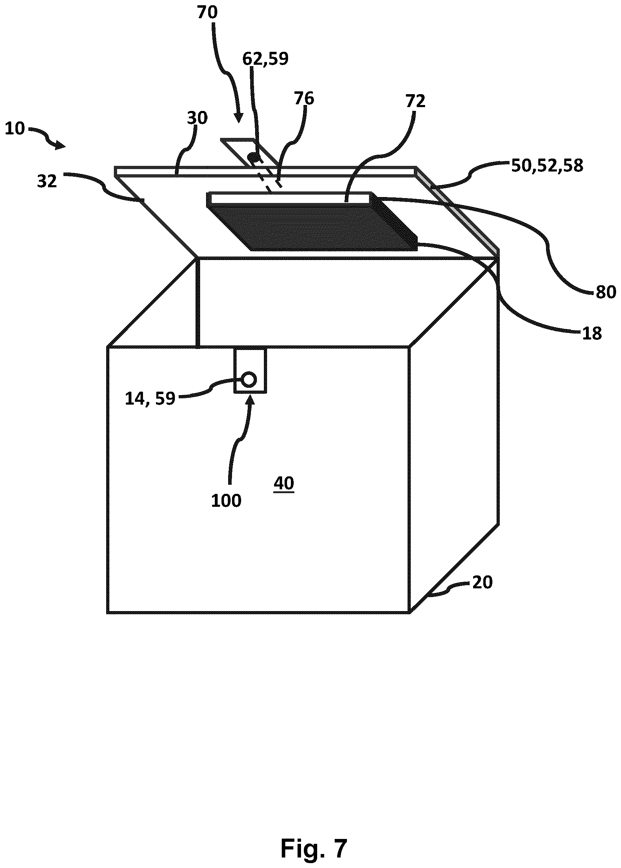

Fig. 7 illustrates a third embodiment of the electronic seal 70. The electronic seal 70 is part of a package 10 as described in the other figures 1-3. The lid 30 has a flap 60 with a second mating unit 62 in the form of a button part 59. One of the walls 40 of the package comprises a first mating unit 14 in the form of a complementary button part 59. The mating units 14, 62 together form a button 59. The electronic seal 70 comprises an electronic circuit 76 going through the button parts 59 and the sensor 72 is configured to measure the voltage drop and or resistance of the electronic circuit 76. In this embodiment the sensor forms part of the smart tag 80, however it could be a separate unit in communication with the smart tag 80.

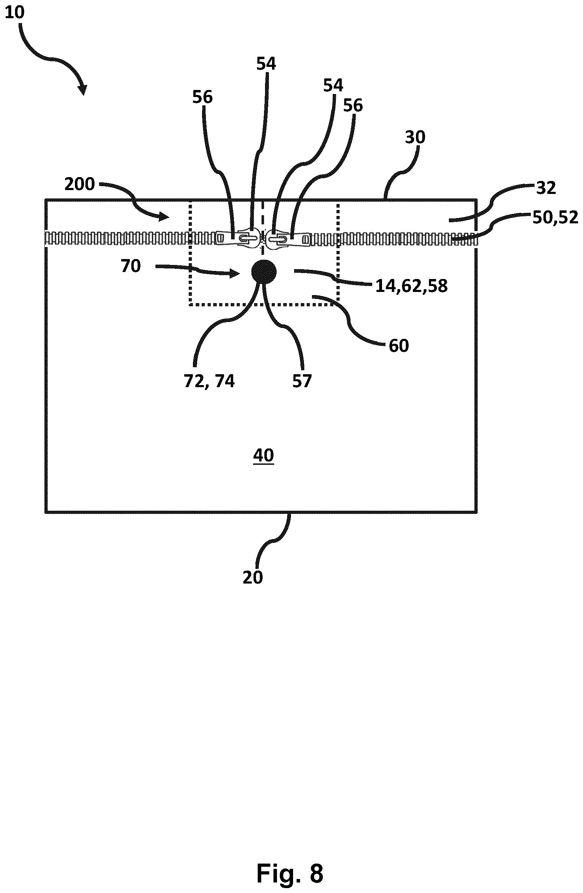

Fig. 8 illustrates an embodiment of the package 10 wherein a puller 56 and a slider 54 are positioned under the flap 60. The package 10 comprises a slide fastener 52 along the strip 50. The slide fastener comprises two sliders 54 each having a slider 54.

The package 10 is set in the connected seal state and both sliders 54 and pullers 56 are positioned under the flap 60 which has a second mating unit 62 engaging a first mating unit 14. The mating units being a hook and loop tape 58.

The electronic seal 70 comprises a hall sensor 72 in the flap 60, which measures a magnetic field from permanent magnetic material 57 connected to the wall 40 of the package 10. In the shown embodiment the permanent magnetic material is positioned below the slides 54 but the permanent magnetic material 57 could form part of the sliders 54 or pullers 56.

## Claims

1. A reusable package (10) for use in a parcel distribution system, the package (10) comprising
- a base (20) and an opposite lid (30) defining an internal space (12), wherein the package (10) comprises a closable opening (32) for enabling access to the internal space (12), the closeable opening (32) being closable along a strip (50) by a reversible slide fastener (52) or hook and loop tape (58);
- a first mating unit (14) positioned on the package (10);
- a flap (60) extending from the package (10), wherein the flap (10) and the first mating unit (14) are positioned on opposite sides of the strip (50), the flap (60) including a second mating unit (62) complementary to the first mating unit (14), wherein the flap (60) is configured to extend past the strip such that the mating units (14,62) can couple;
- an electronic seal (70) including a sensor (72) configured for detecting whether the mating units (14,62) are coupled and/or uncoupled;
- a smart tag (80) connected to the sensor (72), the smart tag (80) comprising a local power storage (81), a communication module (82), a processor (84) and a computer-readable medium (86) having stored thereon a computer program causing the processor (84) to determine a change of state as a function of data from the sensor between
- a broken seal state (100), wherein the mating units (14,62) are uncoupled; and
- a connected seal state (200) wherein the mating units (14,62) are coupled,
wherein the computer program further causes the processor to store state history on the computer-readable medium (86).

2. A package (10) according to claim 1, wherein the flap (60) comprises a width greater than the length of the slider (54) and the puller (56) of the slide fastener (52), such that the slider (54) and the puller (56) are inaccessible without uncoupling the mating units (14,62).

3. A package (10) according to claim 1 or 2, wherein
- the sensor (72) is a hall sensor (74) positioned on the flap (60) at or near the second mating unit (62) and the package (10) comprises permanent magnetic material (57) at or near the first mating unit (14); or
- the sensor (70) is a hall sensor (74) positioned on the package (10) at or near the first mating unit (14) and the flap (60) comprises permanent magnetic material (57) at or near the second mating unit (62).

4. A package (10) according to any of claims 1 to 3, wherein the mating units (14,62) include complementary button parts (59), wherein the electronic seal (70) comprises an electronic circuit (76) going through the button parts (59) and the sensor (72) is configured to measure the voltage drop and or resistance of the electronic circuit (76).

5. A package (10) according to any of claims 1 to 4, wherein the mating units (14,62) comprise complementary hook and loop tape (58).

6. A package (10) according to any of claims 1 to 5, wherein the smart tag (80) includes a display (88), and the computer program is further configured to cause the display (88) to show the state history.

7. A package (10) according to any of claims 1 to 6, wherein the smart tag (80) is further configured to receive unique identifiers about the person or legal entity causing a change of state before or after the change of state.

8. A package (10) according to any of claims 1 to 7, wherein the smart tag (80) is further configured to reset the state history as a function of received instructions.

9. A package (10) according to any of claims 1 to 8, wherein the slider (54) and/or the puller (56) of the slide fastener (52) include permanent magnetic material (57), and the sensor (72) is a hall sensor (74) positioned on the flap (60) at an overlap with the slide fastener (52) during use.

10. A package (10) according to any of claims 1 to 9, wherein the electronic seal (70) includes one or more tilt sensors and/or gyroscopes and/or accelerometers attached to the closeable opening (32) and the computer program is further configured to cause the processor to determine a change of state as a function of data including data from the one or more tilt sensors and/or gyroscopes and/or accelerometers.

11. A package (10) according to any of claims 1 to 10, wherein the package (10) comprises one or more walls (40) extending between the base (20) and the lid (30).

12. A package (10) according to any of claims 9 or 10, wherein the closeable opening (32) forms part of the lid (30) and the electronic seal (70) further includes one or more tilt sensors and/or gyroscopes and/or accelerometers attached to the base (20) and/or the one or more walls (40), wherein the computer program is further configured to cause the processor to determine a change of state as a function of comparing data between tilt sensors and/or gyroscopes and/or accelerometers attached to the closeable opening (32) and attached to the one or more walls (40) and/or base (20).

13. A package (10) according to any of claims 1 to 12, wherein the package is made of recyclable plastics or fabrics such as cloth.
